(19) Europäisches Patentamt / European Patent Office / Office européen des brevets

(11) **EP 2 378 296 B1**

(12) **EUROPEAN PATENT SPECIFICATION**

(45) Date of publication and mention
of the grant of the patent:
**23.03.2016 Bulletin 2016/12**

(51) Int Cl.:
***G01R 27/16*** *(2006.01)*   ***G01R 35/02*** *(2006.01)*

(21) Application number: **10160295.1**

(22) Date of filing: **19.04.2010**

(54) **Method and arrangement for determining impedance values**

Verfahren und Anordnung zum Bestimmen von Impedanzwerten

Procédé et agencement pour déterminer des valeurs d'impédance

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(43) Date of publication of application:
**19.10.2011 Bulletin 2011/42**

(73) Proprietor: **ABB Technology AG**
**8050 Zürich (CH)**

(72) Inventors:
• **Wahlroos, Ari**
**65350, Vaasa (FI)**

• **Altonen, Janne**
**37800, Toijala (FI)**

(74) Representative: **Kolster Oy Ab**
**Iso Roobertinkatu 23**
**PO Box 148**
**00121 Helsinki (FI)**

(56) References cited:
**EP-A1- 1 324 455**   **EP-A1- 1 727 257**
**EP-A1- 1 870 717**   **JP-A- 5 180 885**

EP 2 378 296 B1

**Description**

FIELD OF THE INVENTION

The present invention relates to determining impedance values.

BACKGROUND OF THE INVENTION

EP 1 727 257 A discloses a protection circuit for potential transformers, EP 1 324 455 A discloses electric power transmission network state estimation, and JP 5 180 885 A discloses the insertion of a connecting resistance between the earth and a phase.

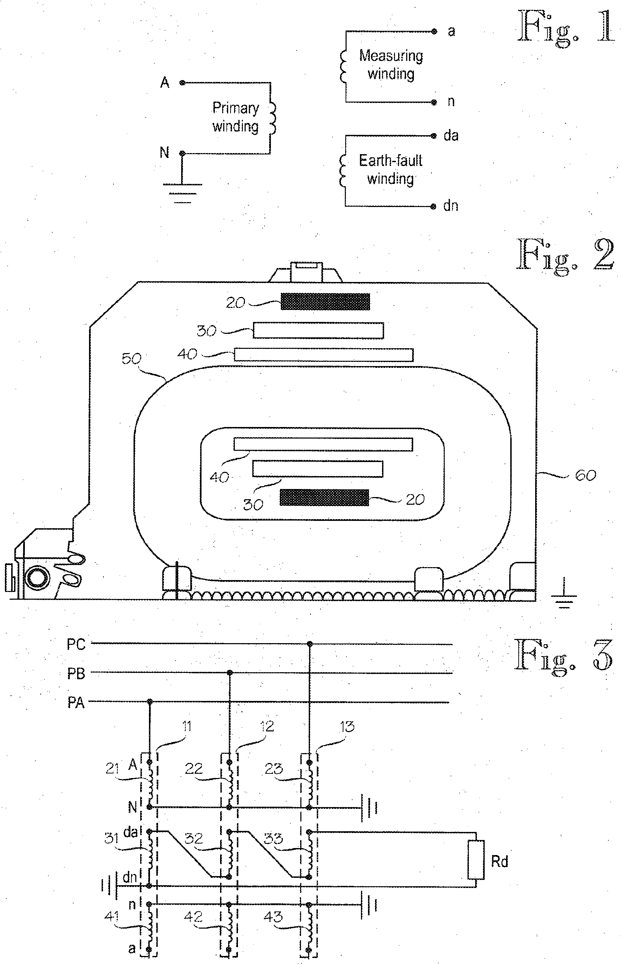

Single pole insulated voltage transformers used in electricity distribution networks are typically equipped with three windings. In addition to a primary winding, transformers have a secondary winding, i.e. a measuring winding, which is used for either measuring or protection purposes, and a tertiary winding, i.e. an earth-fault winding, which is utilized for earth-fault protection purposes. The terminals of the primary, measuring and earth-fault windings are typically denoted as: A-N, a-n and da-dn, respectively. Figure 1 shows a terminal diagram of a single pole insulated voltage transformer with three windings. Typically all three windings are wound around the same magnetic (iron) core. Figure 2 illustrates a principal construction of an exemplary single pole insulated voltage transformer with three windings, i.e. a primary winding 20, an earth-fault winding 30 and a measuring winding 40, wound around a core 50 and enclosed in a housing 60. The fact that all the windings 20, 30, 40 are wound around the same magnetic core 50 makes the windings interlinked through magnetic fluxes. Consequently, when a primary voltage is applied to the primary winding 20, the secondary windings 30, 40 produce secondary voltages that depend on the primary voltage and a turns ratio between the secondary winding in question and the primary winding.

In a three-phase network, the earth-fault windings of three single pole insulated voltage transformers are typically connected in "open-delta" connection. This is due to the fact that during an earth-fault in the primary network, the voltage between the open-delta terminals is related to a residual voltage of the network (voltage between earth and neutral point of the three-phase system). This voltage is utilized in earth-fault protection relays. In addition, typically a resistor is connected between open-delta terminals in order to provide necessary damping power in case of ferro-resonance. Figure 3 shows a typical configuration of three single pole insulated voltage transformers 11, 12, 13 each with primary windings 21, 22, 23, measuring windings 41, 42, 43 and earth-fault windings 31, 32, 33 connected to phases PA, PB, PC of a three-phase network. Earth-fault windings 31, 32, 33 of the three single pole insulated voltage transformers 11, 12, 13 are connected in open-delta connection. A resistor Rd is connected between open-delta terminals in order to provide necessary damping power in case of ferro-resonance. The primary voltages of the three phases PA, PB, PC of the three-phase network may then be obtained on the basis of the secondary voltages measured from the measuring windings 41, 42, 43 and the turns ratio between the primary winding and the measuring winding.

However, inductive voltage transformers typically have a limited measurement accuracy compared with e.g. voltage sensors. The accuracy of the inductive voltage transformers is disturbed especially when simall amplitude voltages, e.g. the faulted phase voltage during earth faults, are being measured. The accuracy of the inductive voltage transformers can be improved by taking into account parameters affecting the accuracy. Such parameters in a transformer configuration of Figure 3 may include e.g. the following:

$\overline{Z}1$ = Impedance of the primary winding
$\overline{Z}2$ = Impedance of the secondary winding
$\overline{Z}3$ = Impedance of the tertiary winding
$\overline{Z}ws$ = Secondary wiring impedance
$\overline{Z}wn$ = Wiring impedance of the neutral conductor of the secondary burden
$\overline{Z}wd$ = Tertiary wiring impedance
$\overline{Z}bs$ = Secondary burden impedance
$\overline{Z}bd$ = Tertiary burden impedance
$\overline{R}d$ = Ferroresonance damping resistance

Parameter Rd, the resistance of a ferro-resonance damping resistor, value is typically known. This is because it is a separate component and it is dimensioned when ordered.

Transformer-related values $\overline{Z}1$, $\overline{Z}2$ and $\overline{Z}3$ are transformer-design-specific. They can be determined by short-circuit impedance tests. The problem is that such tests are not routine tests for voltage transformers. If the transformers are already installed in the substation, the determination of $\overline{Z}1$, $\overline{Z}2$ and $\overline{Z}3$ values is difficult to conduct. Secondary and tertiary circuit related values $\overline{Z}ws$, $\overline{Z}wn$, $\overline{Z}wd$, $\overline{Z}bs$, $\overline{Z}bd$ might also be challenging to determine in practice. There exists test equipment, which can determine the voltage transformer burden by simple measurement procedure. The downside is that the test equipment is very expensive.

BRIEF DESCRIPTION OF THE INVENTION

An object of the present invention is thus to provide a method and an apparatus for implementing the method so as to overcome the above drawback or at least to alleviate it. The objects of the invention are achieved by a method and an arrangement which are characterized by what is stated in the independent claims. The preferred embodiments of the invention are disclosed in the dependent claims.

The invention is based on the idea of conducting a single-phase trial earth fault in the three phase electric system into which a transformer configuration comprising three single pole voltage transformers is connected to and measuring a primary voltage from a primary winding connected to the faulted phase and secondary voltages from secondary windings. Values of one or more impedance parameters related to the transformer configuration are then evaluated on the basis of these measured values and an equation relating to each other the primary voltage, the secondary voltages and the one or more impedance parameters related to the transformer configuration. According to an embodiment, when the number of the impedance parameters whose values are to be evaluated is two or more, an iterative optimization procedure is preferably utilized to find by iteration such values of the two or more impedance parameters related to the transformer configuration that minimize a difference between the measured value of the primary voltage and a calculated value of the primary voltage, which is calculated on the basis of the equation, the measured secondary voltages and the values of the two or more impedance parameters.

An advantage of the method and arrangement of the invention is that the values for one or more impedance parameters related to the transformer configuration can be determined using a simple arrangement. Because the measurements are made during an earth fault, the determined values for the one or more impedance parameters automatically take into account the conditions and possible measurement inaccuracies and errors during a fault condition due to e.g. voltage transformer characteristics, and thus such determined values provide a compensation for such inaccuracies and errors.

BRIEF DESCRIPTION OF THE DRAWINGS

In the following the invention will be described in greater detail by means of preferred embodiments with reference to the accompanying drawings, in which

Figure 1 shows a terminal diagram of a single pole insulated voltage transformer with three windings;
Figure 2 shows a principal construction of a single pole insulated voltage transformer with three windings;
Figure 3 shows a configuration of three single pole insulated voltage transformers each with three windings;
Figure 4 shows an equivalent circuit of three single pole instrument voltage transformers where secondary burden is star-connected;
Figure 5 shows an equivalent circuit of three single pole instrument voltage transformers where secondary burden is delta-connected (after delta-star conversion); and
Figure 6 shows an apparatus according to an embodiment of the invention.

DETAILED DESCRIPTION OF THE INVENTION

The application of the invention is not limited to any specific system, but it can be used in connection with various electric systems. Moreover, the use of the invention is not limited to systems or devices employing any specific fundamental frequency or any specific voltage level.

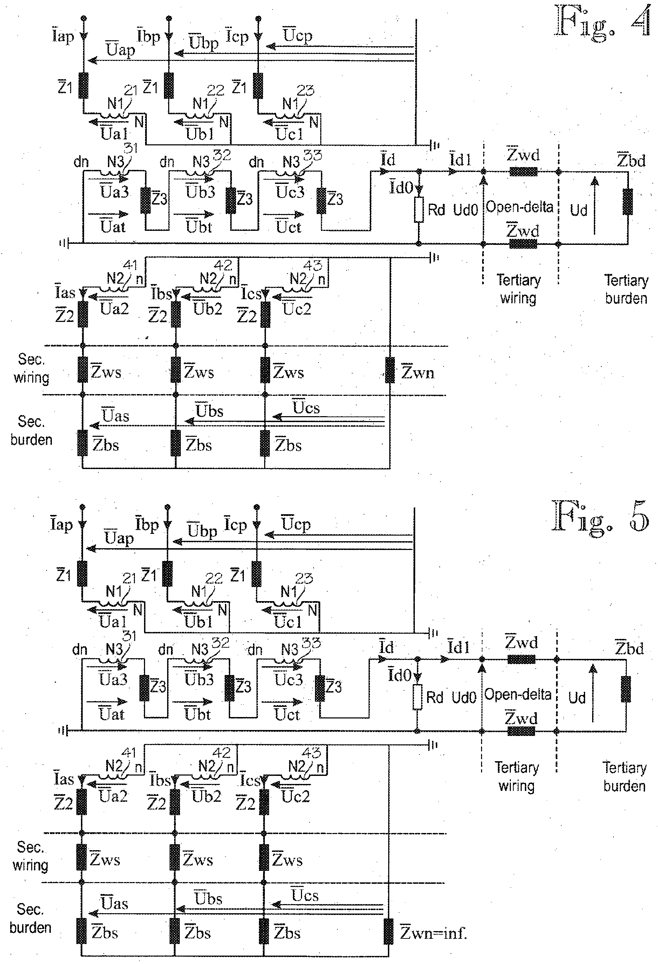

In order to analyze the behavior of an exemplary configuration of three single pole insulated voltage transformers with three windings in a three-phase network, the electrical equivalent schemes of figures 4 and 5 can be derived.

The secondary burden (impedance $\overline{Z}bs$) is connected to transformers' secondary (measuring) winding 41, 42, 43 terminals. The connection is made through wiring impedance $\overline{Z}ws$. Figure 4 illustrates a star-connected burden, where the common neutral conductor is modeled with wiring impedance $\overline{Z}wn$. The equivalent scheme presented in Figure 5 can be used in case the burden is delta connected. In this case the neutral conductor impedance $\overline{Z}wn$ equals infinity. $\overline{Z}bs$ values can be obtained using delta-star conversion for impedances.

The tertiary (earth-fault) windings 31, 32, 33 are connected in "open-delta" configuration for earth-fault protection purposes. Resistor Rd is connected between open-delta terminals in order to prevent ferro-resonance. Tertiary burden (impedance $\overline{Z}bd$) is connected to transformers' tertiary terminals. The connection is made through wiring impedance $\overline{Z}wd$.

Notations used in Figures 4 and 5:

$\overline{U}ap$ = Phase PA primary phase-to-earth voltage

$\overline{U}bp$ = Phase PB primary phase-to-earth voltage
$\overline{U}cp$ = Phase PC primary phase-to-earth voltage

$\overline{U}as$ = Phase PA secondary phase-to-earth voltage
$\overline{U}bs$ = Phase PB secondary phase-to-earth voltage
$\overline{U}cs$ = Phase PC secondary phase-to-earth voltage

$\overline{U}at$ = Phase PA tertiary phase-to-earth voltage
$\overline{U}bt$ = Phase PB tertiary phase-to-earth voltage
$\overline{U}ct$ = Phase PC tertiary phase-to-earth voltage

$\overline{Z}1$ = Impedance of the primary winding
$\overline{Z}2$ = Impedance of the secondary winding
$\overline{Z}3$ = Impedance of the tertiary winding
$\overline{Z}ws$ = Secondary wiring impedance
$\overline{Z}wn$ = Wiring impedance of the neutral conductor of the secondary burden
$\overline{Z}wd$ = Tertiary wiring impedance
$\overline{Z}bs$ = Secondary burden impedance
$\overline{Z}bd$ = Tertiary burden impedance
Rd = Ferro-resonance damping resistance

N1 = Number of turns of wire in the primary winding
N2 = Number of turns of wire in the secondary winding
N3 = Number of turns of wire in the tertiary winding

$\overline{I}ap$ = Phase PA primary phase current
$\overline{I}bp$ = Phase PB primary phase current
$\overline{I}cp$ = Phase PC primary phase current

$\overline{I}as$ = Phase PA secondary phase current
$\overline{I}bs$ = Phase PB secondary phase current
$\overline{I}cs$ = Phase PC secondary phase current

$\overline{U}a1$ = Voltage over the primary winding, phase PA
$\overline{U}b1$ = Voltage over the primary winding, phase PB
$\overline{U}c1$ = Voltage over the primary winding, phase PC

$\overline{U}a2$ = Voltage over the secondary winding, phase PA
$\overline{U}b2$ = Voltage over the secondary winding, phase PB
$\overline{U}c2$ = Voltage over the secondary winding, phase PC

$\overline{U}a3$ = Voltage over the tertiary winding, phase PA
$\overline{U}b3$ = Voltage over the tertiary winding, phase PB
$\overline{U}c3$ = Voltage over the tertiary winding, phase PC

$\overline{I}d0$ = Tertiary current through the damping resistor
$\overline{I}d1$ = Tertiary current through the tertiary burden
$\overline{I}d$ = Total tertiary current
$\overline{U}d$ = Open-delta voltage
$\overline{U}d0$ = Voltage over the damping resistor = $\overline{U}at + \overline{U}bt + \overline{U}ct$

The transformers are modeled with their respective longitudinal impedances $\overline{Z}1$, $\overline{Z}2$ and $\overline{Z}3$, which include a winding resistance and a leakage reactance. These are assumed to be similar for each phase transformer. Values for $\overline{Z}1$, $\overline{Z}2$ and $\overline{Z}3$ can be derived from short-circuit test results or obtained from the manufacturer of the transformer, for example. The effect of an external cabling/wiring for instrumentation can be taken into account by wiring impedances $\overline{Z}ws$, $\overline{Z}wn$ and $\overline{Z}wd$. Burden can be taken into account with impedances $\overline{Z}bs$ and $\overline{Z}bd$. From Figures 4 and 5, the following equations can be written (equations with "a" apply for Figure 4, equations with "b" apply for Figure 5):

Phase a:

$$\overline{U}ap - \overline{Z}1 * \overline{I}ap = \overline{U}a1 \qquad \text{(eq 1)}$$

$$\overline{U}a2 - (\overline{Z}2 + \overline{Z}ws) * \overline{I}as = \overline{U}as + \overline{Z}wn * (\overline{I}as + \overline{I}bs + \overline{I}cs) \qquad \text{(eq 2a)}$$

$$\overline{U}a2 - (\overline{Z}2 + \overline{Z}ws) * \overline{I}as = \overline{U}as \qquad \text{(eq 2b)}$$

$$\overline{U}a3 - \overline{Z}3 * \overline{I}d = \overline{U}at \qquad \text{(eq 3)}$$

$$N1 * \overline{I}ap = N2 * \overline{I}as + N3 * \overline{I}d \qquad \text{(eq 4)}$$

$$\overline{U}as = \overline{Z}bs * \overline{I}as \qquad \text{(eq 5a)}$$

$$\overline{U}as = \overline{Z}bs * \overline{I}as + \overline{Z}wn * (\overline{I}as + \overline{I}bs + \overline{I}cs) \qquad \text{(eq 5b)}$$

$$\overline{U}a2 = (N2 / N1) * \overline{U}a1 \qquad \text{(eq 6)}$$

$$\overline{U}a3 = (N3 / N1) * \overline{U}a1 \qquad \text{(eq 7)}$$

Phase b:

$$\overline{U}bp - \overline{Z}1 * \overline{I}bp = \overline{U}b1 \qquad \text{(eq 8)}$$

$$\overline{U}b2 - (\overline{Z}2 + \overline{Z}ws) * \overline{I}bs = \overline{U}bs + \overline{Z}wn * (\overline{I}as + \overline{I}bs + \overline{I}cs) \qquad \text{(eq 9a)}$$

$$\overline{U}b2 - (\overline{Z}2 + \overline{Z}ws) * \overline{I}bs = \overline{U}bs \qquad \text{(eq 9b)}$$

$$\overline{U}b3 - \overline{Z}3 * \overline{I}d = \overline{U}bt \qquad \text{(eq 10)}$$

$$N1 * \overline{I}bp = N2 * \overline{I}bs + N3 * \overline{I}d \qquad \text{(eq 11)}$$

$$\overline{U}bs = \overline{Z}bs * \overline{I}bs \qquad \text{(eq 12a)}$$

$$\overline{U}bs = \overline{Z}bs * \overline{I}bs + \overline{Z}wn * (\overline{I}as + \overline{I}bs + \overline{I}cs) \qquad \text{(eq 12b)}$$

$$\overline{U}b2 = (N2 / N1) * \overline{U}b1 \qquad \text{(eq 13)}$$

$$\overline{U}b3 = (N3/N1) * \overline{U}b1 \qquad \text{(eq 14)}$$

Phase c:

$$\overline{U}cp - \overline{Z}1 * \overline{I}cp = \overline{U}c1 \qquad \text{(eq 15)}$$

$$\overline{U}c2 - (\overline{Z}2 + \overline{Z}ws) * \overline{I}cs = \overline{U}cs + \overline{Z}wn * (\overline{I}as + \overline{I}bs + \overline{I}cs) \qquad \text{(eq 16a)}$$

$$\overline{U}c2 - (\overline{Z}2 + \overline{Z}ws) * \overline{I}cs = \overline{U}cs \qquad \text{(eq 16b)}$$

$$\overline{U}c3 - \overline{Z}3 * \overline{I}d = \overline{U}ct \qquad \text{(eq 17)}$$

$$N1 * \overline{I}cp = N2 * \overline{I}cs + N3 * \overline{I}d \qquad \text{(eq 18)}$$

$$\overline{U}cs = \overline{Z}bs * \overline{I}cs \qquad \text{(eq 19a)}$$

$$\overline{U}cs = \overline{Z}bs * \overline{I}cs + \overline{Z}wn * (\overline{I}as + \overline{I}bs + \overline{I}cs) \qquad \text{(eq 19b)}$$

$$\overline{U}c2 = (N2/N1) * \overline{U}c1 \qquad \text{(eq 20)}$$

$$\overline{U}c3 = (N3/N1) * \overline{U}c1 \qquad \text{(eq 21)}$$

And

$$\overline{I}d0 * Rd = (\overline{U}at + \overline{U}bt + \overline{U}ct) \qquad \text{(eq 22)}$$

$$\overline{I}d0 * Rd - \overline{Z}wd * \overline{I}d1 = (\overline{Z}bd + \overline{Z}wd) * \overline{I}d1 \qquad \text{(eq 23)}$$

$$\overline{I}d = \overline{I}d0 + \overline{I}d1 \qquad \text{(eq 24)}$$

In equations 1 to 24 the known voltages are assumed to be:

$\overline{U}as$ = Phase PA secondary phase-to-earth voltage
$\overline{U}bs$ = Phase PB secondary phase-to-earth voltage
$\overline{U}cs$ = Phase PC secondary phase-to-earth voltage

The known impedances and transformer-related values are:

$\overline{Z}1$ = Impedance of the primary winding
$\overline{Z}2$ = Impedance of the secondary winding

$\overline{Z}3$ = Impedance of the tertiary winding
$\overline{Z}ws$ = Wiring impedance of the secondary circuit
$\overline{Z}wn$ = Wiring impedance of the secondary circuit, neutral conductor
$\overline{Z}wd$ = Wiring impedance of the open delta
$\overline{Z}bs$ = Secondary burden impedance
$\overline{Z}bd$ = Tertiary burden impedance
Rd = Ferro-resonance damping resistance
N1 = Number of turns of wire in the primary winding
N2 = Number of turns of wire in the secondary winding
N3 = Number of turns of wire in the tertiary winding

All other voltages and currents can be calculated as a function of secondary phase-to-earth voltage and known impedances and transformer-related values. Thus, accurate primary phase-to-earth voltages can be obtained: In case the secondary burden is star-connected and the common neutral conductor wiring impedance is $\overline{Z}wn$ (refer to Figure 4), equations 25-27 apply:

(Eq. 25) $\bar{U}ap =$

$1/N2/\bar{Z}bs*(3*N1^{2}*\bar{Z}wn*\bar{U}as*Rd*\bar{Z}3+6*N1^{2}*\bar{Z}wn*\bar{U}as*\bar{Z}3*\bar{Z}wd+$
$3*N1^{2}*\bar{Z}wn*\bar{U}as*\bar{Z}3*\bar{Z}bd+2*N1^{2}*\bar{Z}wn*\bar{U}as*Rd*\bar{Z}wd+N1^{2}*\bar{Z}wn*\bar{U}as*Rd*\bar{Z}bd+$
$3*N1^{2}*\bar{Z}wn*\bar{U}bs*Rd*\bar{Z}3+6*N1^{2}*\bar{Z}wn*\bar{U}bs*\bar{Z}3*\bar{Z}wd+$
$3*N1^{2}*\bar{Z}wn*\bar{U}bs*\bar{Z}3*\bar{Z}bd+2*N1^{2}*\bar{Z}wn*\bar{U}bs*Rd*\bar{Z}wd+N1^{2}*\bar{Z}wn*\bar{U}bs*Rd*\bar{Z}bd+$
$3*N1^{2}*\bar{Z}wn*\bar{U}cs*Rd*\bar{Z}3+6*N1^{2}*\bar{Z}wn*\bar{U}cs*\bar{Z}3*\bar{Z}wd3*N1^{2}*\bar{Z}wn*\bar{U}cs*\bar{Z}3*\bar{Z}bd+$
$2*N1^{2}*\bar{Z}wn*\bar{U}cs*Rd*\bar{Z}wd+N1^{2}*\bar{Z}wn*\bar{U}cs*Rd*\bar{Z}bd+2*\bar{Z}1*N3^{2}*\bar{Z}wd*\bar{U}bs*\bar{Z}bs+$
$3*\bar{Z}1*N3^{2}*\bar{Z}bd*\bar{Z}wn*\bar{U}bs+\bar{Z}1*N3^{2}*\bar{Z}bd*\bar{U}as*\bar{Z}ws+3*\bar{Z}1*N3^{2}*\bar{Z}bd*\bar{Z}wn*\bar{U}as+$
$\bar{Z}1*N3^{2}*\bar{Z}bd*\bar{U}as*\bar{Z}2+\bar{Z}1*N3^{2}*\bar{Z}bd*\bar{U}as*\bar{Z}bs+\bar{Z}1*N3^{2}*Rd*\bar{U}as*\bar{Z}bs+$
$6*\bar{Z}1*N3^{2}*\bar{Z}wd*\bar{Z}wn*\bar{U}cs+3*\bar{Z}1*N3^{2}*\bar{Z}bd*\bar{Z}wn*\bar{U}cs+\bar{Z}1*N3^{2}*\bar{Z}bd*\bar{U}bs*\bar{Z}2+$
$\bar{Z}1*N3^{2}*\bar{Z}bd*\bar{U}cs*\bar{Z}2+\bar{Z}1*N3^{2}*\bar{Z}bd*\bar{U}cs*\bar{Z}ws+\bar{Z}1*N3^{2}*\bar{Z}bd*\bar{U}cs*\bar{Z}bs+$
$\bar{Z}1*N3^{2}*\bar{Z}bd*\bar{U}bs*\bar{Z}ws+\bar{Z}1*N3^{2}*\bar{Z}bd*\bar{U}bs*\bar{Z}bs+\bar{Z}1*N3^{2}*Rd*\bar{U}as*\bar{Z}2+$
$\bar{Z}1*N3^{2}*Rd*\bar{U}as*\bar{Z}ws+3*\bar{Z}1*N3^{2}*Rd*\bar{Z}wn*\bar{U}as+3*\bar{Z}1*N3^{2}*Rd*\bar{Z}wn*\bar{U}bs+$
$3*\bar{Z}1*N3^{2}*Rd*\bar{Z}wn*\bar{U}cs+\bar{Z}1*N3^{2}*Rd*\bar{U}bs*\bar{Z}2+\bar{Z}1*N3^{2}*Rd*\bar{U}cs*\bar{Z}2+$
$\bar{Z}1*N3^{2}*Rd*\bar{U}cs*\bar{Z}ws+\bar{Z}1*N3^{2}*Rd*\bar{U}cs*\bar{Z}bs+\bar{Z}1*N3^{2}*Rd*\bar{U}bs*\bar{Z}ws+$
$\bar{Z}1*N3^{2}*Rd*\bar{U}bs*\bar{Z}bs+2*\bar{Z}1*N3^{2}*\bar{Z}wd*\bar{U}as*\bar{Z}2+2*\bar{Z}1*N3^{2}*\bar{Z}wd*\bar{U}as*\bar{Z}ws+$
$2*\bar{Z}1*N3^{2}*\bar{Z}wd*\bar{U}as*\bar{Z}bs+6*\bar{Z}1*N3^{2}*\bar{Z}wd*\bar{Z}wn*\bar{U}as+$
$6*\bar{Z}1*N3^{2}*\bar{Z}wd*\bar{Z}wn*\bar{U}bs+2*\bar{Z}1*N3^{2}*\bar{Z}wd*\bar{U}bs*\bar{Z}2+$
$2*\bar{Z}1*N3^{2}*\bar{Z}wd*\bar{U}cs*\bar{Z}ws+2*\bar{Z}1*N3^{2}*\bar{Z}wd*\bar{U}cs*\bar{Z}bs+$
$2*\bar{Z}1*N3^{2}*\bar{Z}wd*\bar{U}bs*\bar{Z}ws+2*\bar{Z}1*N3^{2}*\bar{Z}wd*\bar{U}cs*\bar{Z}2+3*N1^{2}*\bar{U}as*\bar{Z}2*Rd*\bar{Z}3+$
$6*N1^{2}*\bar{U}as*\bar{Z}2*\bar{Z}3*\bar{Z}wd+3*N1^{2}*\bar{U}as*\bar{Z}2*\bar{Z}3*\bar{Z}bd+2*N1^{2}*\bar{U}as*\bar{Z}2*Rd*\bar{Z}wd+$
$N1^{2}*\bar{U}as*\bar{Z}2*Rd*\bar{Z}bd+3*N1^{2}*\bar{U}as*\bar{Z}ws*Rd*\bar{Z}3+6*N1^{2}*\bar{U}as*\bar{Z}ws*\bar{Z}3*\bar{Z}wd+$
$3*N1^{2}*\bar{U}as*\bar{Z}ws*\bar{Z}3*\bar{Z}bd+2*N1^{2}*\bar{U}as*\bar{Z}ws*Rd*\bar{Z}wd+N1^{2}*\bar{U}as*\bar{Z}ws*Rd*\bar{Z}bd+$
$3*N1^{2}*\bar{U}as*\bar{Z}bs*Rd*\bar{Z}3+6*N1^{2}*\bar{U}as*\bar{Z}bs*\bar{Z}3*\bar{Z}wd+3*N1^{2}*\bar{U}as*\bar{Z}bs*\bar{Z}3*\bar{Z}bd+$
$2*N1^{2}*\bar{U}as*\bar{Z}bs*Rd*\bar{Z}wd+N1^{2}*\bar{U}as*\bar{Z}bs*Rd*\bar{Z}bd+3*\bar{Z}1*N2^{2}*\bar{U}as*Rd*\bar{Z}3+$
$6*\bar{Z}1*N2^{2}*\bar{U}as*\bar{Z}3*\bar{Z}wd+3*\bar{Z}1*N2^{2}*\bar{U}as*\bar{Z}3*\bar{Z}bd+2*\bar{Z}1*N2^{2}*\bar{U}as*Rd*\bar{Z}wd+$

$\bar{Z}1*N2^{2}*\bar{U}as*Rd*\bar{Z}bd)/N1/(3*Rd*\bar{Z}3+6*\bar{Z}3*\bar{Z}wd+3*\bar{Z}3*\bar{Z}bd+2*Rd*\bar{Z}wd+$
$Rd*\bar{Z}bd)$

(Eq. 26) $\overline{U}bp =$

$$1/N2/\overline{Z}bs*(3*N1^{2}*\overline{Z}wn*\overline{U}as*Rd*\overline{Z}3+6*N1^{2}*\overline{Z}wn*\overline{U}as*\overline{Z}3*\overline{Z}wd+$$
$$3*N1^{2}*\overline{Z}wn*\overline{U}as*\overline{Z}3*\overline{Z}bd+2*N1^{2}*\overline{Z}wn*\overline{U}as*Rd*\overline{Z}wd+N1^{2}*\overline{Z}wn*\overline{U}as*Rd*\overline{Z}bd+$$
$$3*N1^{2}*\overline{Z}wn*\overline{U}bs*Rd*\overline{Z}3+6*N1^{2}*\overline{Z}wn*\overline{U}bs*\overline{Z}3*\overline{Z}wd+$$
$$3*N1^{2}*\overline{Z}wn*\overline{U}bs*\overline{Z}3*\overline{Z}bd+2*N1^{2}*\overline{Z}wn*\overline{U}bs*Rd*\overline{Z}wd+N1^{2}*\overline{Z}wn*\overline{U}bs*Rd*\overline{Z}bd+$$
$$3*N1^{2}*\overline{Z}wn*\overline{U}cs*Rd*\overline{Z}3+6*N1^{2}*\overline{Z}wn*\overline{U}cs*\overline{Z}3*\overline{Z}wd+$$
$$3*N1^{2}*\overline{Z}wn*\overline{U}cs*\overline{Z}3*\overline{Z}bd+2*N1^{2}*\overline{Z}wn*\overline{U}cs*Rd*\overline{Z}wd+N1^{2}*\overline{Z}wn*\overline{U}cs*Rd*\overline{Z}bd+$$
$$2*\overline{Z}1*N3^{2}*\overline{Z}wd*\overline{U}bs*\overline{Z}bs+3*\overline{Z}1*N3^{2}*\overline{Z}bd*\overline{Z}wn*\overline{U}bs+\overline{Z}1*N3^{2}*\overline{Z}bd*\overline{U}as*\overline{Z}ws+$$
$$3*\overline{Z}1*N3^{2}*\overline{Z}bd*\overline{Z}wn*\overline{U}as+\overline{Z}1*N3^{2}*\overline{Z}bd*\overline{U}as*\overline{Z}2+\overline{Z}1*N3^{2}*\overline{Z}bd*\overline{U}as*\overline{Z}bs+$$
$$\overline{Z}1*N3^{2}*Rd*\overline{U}as*\overline{Z}bs+6*\overline{Z}1*N3^{2}*\overline{Z}wd*\overline{Z}wn*\overline{U}cs+3*\overline{Z}1*N3^{2}*\overline{Z}bd*\overline{Z}wn*\overline{U}cs+$$
$$\overline{Z}1*N3^{2}*\overline{Z}bd*\overline{U}bs*\overline{Z}2+\overline{Z}1*N3^{2}*\overline{Z}bd*\overline{U}cs*\overline{Z}2+\overline{Z}1*N3^{2}*\overline{Z}bd*\overline{U}cs*\overline{Z}ws+$$
$$\overline{Z}1*N3^{2}*\overline{Z}bd*\overline{U}cs*\overline{Z}bs+\overline{Z}1*N3^{2}*\overline{Z}bd*\overline{U}bs*\overline{Z}ws+\overline{Z}1*N3^{2}*\overline{Z}bd*\overline{U}bs*\overline{Z}bs+$$
$$\overline{Z}1*N3^{2}*Rd*\overline{U}as*\overline{Z}2+\overline{Z}1*N3^{2}*Rd*\overline{U}as*\overline{Z}ws+3*\overline{Z}1*N3^{2}*Rd*\overline{Z}wn*\overline{U}as+$$
$$3*\overline{Z}1*N3^{2}*Rd*\overline{Z}wn*\overline{U}bs+3*\overline{Z}1*N3^{2}*Rd*\overline{Z}wn*\overline{U}cs+\overline{Z}1*N3^{2}*Rd*\overline{U}bs*\overline{Z}2+$$
$$\overline{Z}1*N3^{2}*Rd*\overline{U}cs*\overline{Z}2+\overline{Z}1*N3^{2}*Rd*\overline{U}cs*\overline{Z}ws+\overline{Z}1*N3^{2}*Rd*\overline{U}cs*\overline{Z}bs+$$
$$\overline{Z}1*N3^{2}*Rd*\overline{U}bs*\overline{Z}ws+\overline{Z}1*N3^{2}*Rd*\overline{U}bs*\overline{Z}bs+2*\overline{Z}1*N3^{2}*\overline{Z}wd*\overline{U}as*\overline{Z}2+$$
$$2*\overline{Z}1*N3^{2}*\overline{Z}wd*\overline{U}as*\overline{Z}ws+2*\overline{Z}1*N3^{2}*\overline{Z}wd*\overline{U}as*\overline{Z}bs+$$
$$6*\overline{Z}1*N3^{2}*\overline{Z}wd*\overline{Z}wn*\overline{U}as+6*\overline{Z}1*N3^{2}*\overline{Z}wd*\overline{Z}wn*\overline{U}bs+$$
$$2*\overline{Z}1*N3^{2}*\overline{Z}wd*\overline{U}bs*\overline{Z}2+2*\overline{Z}1*N3^{2}*\overline{Z}wd*\overline{U}cs*\overline{Z}ws+$$
$$2*\overline{Z}1*N3^{2}*\overline{Z}wd*\overline{U}cs*\overline{Z}bs+2*\overline{Z}1*N3^{2}*\overline{Z}wd*\overline{U}bs*\overline{Z}ws+$$
$$2*\overline{Z}1*N3^{2}*\overline{Z}wd*\overline{U}cs*\overline{Z}2+3*N1^{2}*\overline{U}bs*\overline{Z}2*Rd*\overline{Z}3+6*N1^{2}*\overline{U}bs*\overline{Z}2*\overline{Z}3*\overline{Z}wd+$$
$$3*N1^{2}*\overline{U}bs*\overline{Z}2*\overline{Z}3*\overline{Z}bd+2*N1^{2}*\overline{U}bs*\overline{Z}2*Rd*\overline{Z}wd+N1^{2}*\overline{U}bs*\overline{Z}2*Rd*\overline{Z}bd+$$
$$3*N1^{2}*\overline{U}bs*\overline{Z}ws*Rd*\overline{Z}3+6*N1^{2}*\overline{U}bs*\overline{Z}ws*\overline{Z}3*\overline{Z}wd+$$
$$3*N1^{2}*\overline{U}bs*\overline{Z}ws*\overline{Z}3*\overline{Z}bd+2*N1^{2}*\overline{U}bs*\overline{Z}ws*Rd*\overline{Z}wd+N1^{2}*\overline{U}bs*\overline{Z}ws*Rd*\overline{Z}bd+$$
$$3*N1^{2}*\overline{U}bs*\overline{Z}bs*Rd*\overline{Z}3+6*N1^{2}*\overline{U}bs*\overline{Z}bs*\overline{Z}3*\overline{Z}wd+3*N1^{2}*\overline{U}bs*\overline{Z}bs*\overline{Z}3*\overline{Z}bd+$$
$$2*N1^{2}*\overline{U}bs*\overline{Z}bs*Rd*\overline{Z}wd+N1^{2}*\overline{U}bs*\overline{Z}bs*Rd*\overline{Z}bd+3*\overline{Z}1*N2^{2}*\overline{U}bs*Rd*\overline{Z}3+$$
$$6*\overline{Z}1*N2^{2}*\overline{U}bs*\overline{Z}3*\overline{Z}wd+3*\overline{Z}1*N2^{2}*\overline{U}bs*\overline{Z}3*\overline{Z}bd+2*\overline{Z}1*N2^{2}*\overline{U}bs*Rd*\overline{Z}wd+$$
$$\overline{Z}1*N2^{2}*\overline{U}bs*Rd*\overline{Z}bd)/N1/(3*Rd*\overline{Z}3+6*\overline{Z}3*\overline{Z}wd+3*\overline{Z}3*\overline{Z}bd+2*Rd*\overline{Z}wd+$$
$$Rd*\overline{Z}bd)$$

$$(\text{Eq. 27}) \ \overline{U}cp =$$

$$1/N2/\overline{Z}bs*(3*N1^{2*}\overline{Z}wn*\overline{U}as*Rd*\overline{Z}3+6*N1^{2*}\overline{Z}wn*\overline{U}as*\overline{Z}3*\overline{Z}wd+$$

$$3*N1^{2*}\overline{Z}wn*\overline{U}as*\overline{Z}3*\overline{Z}bd+2*N1^{2*}\overline{Z}wn*\overline{U}as*Rd*\overline{Z}wd+N1^{2*}\overline{Z}wn*\overline{U}as*Rd*\overline{Z}bd+$$

$$3*N1^{2*}\overline{U}cs*\overline{Z}2*Rd*\overline{Z}3+6*N1^{2*}\overline{U}cs*\overline{Z}2*\overline{Z}3*\overline{Z}wd+3*N1^{2*}\overline{U}cs*\overline{Z}2*\overline{Z}3*\overline{Z}bd+$$

$$2*N1^{2*}\overline{U}cs*\overline{Z}2*Rd*\overline{Z}wd+N1^{2*}\overline{U}cs*\overline{Z}2*Rd*\overline{Z}bd+3*N1^{2*}\overline{U}cs*\overline{Z}ws*Rd*\overline{Z}3+$$

$$6*N1^{2*}\overline{U}cs*\overline{Z}ws*\overline{Z}3*\overline{Z}wd+3*N1^{2*}\overline{U}cs*\overline{Z}ws*\overline{Z}3*\overline{Z}bd+$$

$$2*N1^{2*}\overline{U}cs*\overline{Z}ws*Rd*\overline{Z}wd+N1^{2*}\overline{U}cs*\overline{Z}ws*Rd*\overline{Z}bd+3*N1^{2*}\overline{U}cs*\overline{Z}bs*Rd*\overline{Z}3+$$

$$6*N1^{2*}\overline{U}cs*\overline{Z}bs*\overline{Z}3*\overline{Z}wd+3*N1^{2*}\overline{U}cs*\overline{Z}bs*\overline{Z}3*\overline{Z}bd+$$

$$2*N1^{2*}\overline{U}cs*\overline{Z}bs*Rd*\overline{Z}wd+N1^{2*}\overline{U}cs*\overline{Z}bs*Rd*\overline{Z}bd+3*\overline{Z}1*N2^{2*}\overline{U}cs*Rd*\overline{Z}3+$$

$$6*\overline{Z}1*N2^{2*}\overline{U}cs*\overline{Z}3*\overline{Z}wd+3*\overline{Z}1*N2^{2*}\overline{U}cs*\overline{Z}3*\overline{Z}bd+2*\overline{Z}1*N2^{2*}\overline{U}cs*Rd*\overline{Z}wd+$$

$$\overline{Z}1*N2^{2*}\overline{U}cs*Rd*\overline{Z}bd+3*N1^{2*}\overline{Z}wn*\overline{U}bs*Rd*\overline{Z}3+6*N1^{2*}\overline{Z}wn*\overline{U}bs*\overline{Z}3*\overline{Z}wd+$$

$$3*N1^{2*}\overline{Z}wn*\overline{U}bs*\overline{Z}3*\overline{Z}bd+2*N1^{2*}\overline{Z}wn*\overline{U}bs*Rd*\overline{Z}wd+N1^{2*}\overline{Z}wn*\overline{U}bs*Rd*\overline{Z}bd+$$

$$3*N1^{2*}\overline{Z}wn*\overline{U}cs*Rd*\overline{Z}3+6*N1^{2*}\overline{Z}wn*\overline{U}cs*\overline{Z}3*\overline{Z}wd+$$

$$3*N1^{2*}\overline{Z}wn*\overline{U}cs*\overline{Z}3*\overline{Z}bd+2*N1^{2*}\overline{Z}wn*\overline{U}cs*Rd*\overline{Z}wd+N1^{2*}\overline{Z}wn*\overline{U}cs*Rd*\overline{Z}bd+$$

$$2*\overline{Z}1*N3^{2*}\overline{Z}wd*\overline{U}bs*\overline{Z}bs+3*\overline{Z}1*N3^{2*}\overline{Z}bd*\overline{Z}wn*\overline{U}bs+\overline{Z}1*N3^{2*}\overline{Z}bd*\overline{U}as*\overline{Z}ws+$$

$$3*\overline{Z}1*N3^{2*}\overline{Z}bd*\overline{Z}wn*\overline{U}as+\overline{Z}1*N3^{2*}\overline{Z}bd*\overline{U}as*\overline{Z}2+\overline{Z}1*N3^{2*}\overline{Z}bd*\overline{U}as*\overline{Z}bs+$$

$$\overline{Z}1*N3^{2*}Rd*\overline{U}as*\overline{Z}bs+6*\overline{Z}1*N3^{2*}\overline{Z}wd*\overline{Z}wn*\overline{U}cs+3*\overline{Z}1*N3^{2*}\overline{Z}bd*\overline{Z}wn*\overline{U}cs+$$

$$\overline{Z}1*N3^{2*}\overline{Z}bd*\overline{U}bs*\overline{Z}2+\overline{Z}1*N3^{2*}\overline{Z}bd*\overline{U}cs*\overline{Z}2+\overline{Z}1*N3^{2*}\overline{Z}bd*\overline{U}cs*\overline{Z}ws+$$

$$\overline{Z}1*N3^{2*}\overline{Z}bd*\overline{U}cs*\overline{Z}bs+\overline{Z}1*N3^{2*}\overline{Z}bd*\overline{U}bs*\overline{Z}ws+\overline{Z}1*N3^{2*}\overline{Z}bd*\overline{U}bs*\overline{Z}bs+$$

$$\overline{Z}1*N3^{2*}Rd*\overline{U}as*\overline{Z}2+\overline{Z}1*N3^{2*}Rd*\overline{U}as*\overline{Z}ws+3*\overline{Z}1*N3^{2*}Rd*\overline{Z}wn*\overline{U}as+$$

$$3*\overline{Z}1*N3^{2*}Rd*\overline{Z}wn*\overline{U}bs+3*\overline{Z}1*N3^{2*}Rd*\overline{Z}wn*\overline{U}cs+\overline{Z}1*N3^{2*}Rd*\overline{U}bs*\overline{Z}2+$$

$$\overline{Z}1*N3^{2*}Rd*\overline{U}cs*\overline{Z}2+\overline{Z}1*N3^{2*}Rd*\overline{U}cs*\overline{Z}ws+\overline{Z}1*N3^{2*}Rd*\overline{U}cs*\overline{Z}bs+$$

$$\overline{Z}1*N3^{2*}Rd*\overline{U}bs*\overline{Z}ws+\overline{Z}1*N3^{2*}Rd*\overline{U}bs*\overline{Z}bs+2*\overline{Z}1*N3^{2*}\overline{Z}wd*\overline{U}as*\overline{Z}2+$$

$$2*\overline{Z}1*N3^{2*}\overline{Z}wd*\overline{U}as*\overline{Z}ws+2*\overline{Z}1*N3^{2*}\overline{Z}wd*\overline{U}as*\overline{Z}bs+$$

$$6*\overline{Z}1*N3^{2*}\overline{Z}wd*\overline{Z}wn*\overline{U}as+6*\overline{Z}1*N3^{2*}\overline{Z}wd*\overline{Z}wn*\overline{U}bs+$$

$$2*\overline{Z}1*N3^{2*}\overline{Z}wd*\overline{U}bs*\overline{Z}2+2*\overline{Z}1*N3^{2*}\overline{Z}wd*\overline{U}cs*\overline{Z}ws+$$

$$2*\overline{Z}1*N3^{2*}\overline{Z}wd*\overline{U}cs*\overline{Z}bs+2*\overline{Z}1*N3^{2*}\overline{Z}wd*\overline{U}bs*\overline{Z}ws+$$

$$2*\overline{Z}1*N3^{2*}\overline{Z}wd*\overline{U}cs*\overline{Z}2)/N1/(3*Rd*\overline{Z}3+6*\overline{Z}3*\overline{Z}wd+3*\overline{Z}3*\overline{Z}bd+2*Rd*\overline{Z}wd+$$

$$Rd*\overline{Z}bd)$$

In case the secondary burden is delta connected, the equivalent scheme of Figure 5 can be utilized. The neutral conductor impedance $\overline{Z}wn$ equals then infinity. $\overline{Z}bs$ values can be obtained using delta-star conversion for impedances. Equations 28-30 apply:

$$
\begin{aligned}
1/3*(&-3*N1^{2}*\bar{Z}3*Rd*\bar{Z}ws*\bar{U}cs+6*N1^{2}*\bar{Z}3*Rd*\bar{Z}2*\bar{U}as-3*N1^{2}*\bar{Z}3*Rd*\bar{Z}2*\bar{U}bs-\\
&3*N1^{2}*\bar{Z}3*\bar{Z}bd*\bar{Z}2*\bar{U}bs-3*N1^{2}*\bar{Z}3*\bar{Z}bd*\bar{Z}ws*\bar{U}cs-6*N1^{2}*\bar{Z}3*\bar{Z}wd*\bar{Z}2*\bar{U}cs+\\
&12*N1^{2}*\bar{Z}3*\bar{Z}wd*\bar{Z}ws*\bar{U}as-6*N1^{2}*\bar{Z}3*\bar{Z}wd*\bar{Z}ws*\bar{U}bs+\\
&6*N1^{2}*\bar{Z}3*\bar{Z}bd*\bar{Z}2*\bar{U}as+3*\bar{Z}bs*\bar{Z}1*N3^{2}*\bar{Z}bd*\bar{U}as+6*N1^{2}*\bar{Z}3*Rd*\bar{Z}ws*\bar{U}as-\\
&3*N1^{2}*\bar{Z}3*Rd*\bar{Z}ws*\bar{U}bs-N1^{2}*\bar{Z}2*\bar{U}cs*Rd*\bar{Z}bd-2*N1^{2}*\bar{Z}2*\bar{U}cs*Rd*\bar{Z}wd+\\
&3*\bar{Z}bs*\bar{Z}1*N3^{2}*\bar{Z}bd*\bar{U}bs+6*\bar{Z}bs*\bar{Z}1*N3^{2}*\bar{Z}wd*\bar{U}cs+\\
&6*\bar{Z}bs*\bar{Z}1*N3^{2}*\bar{Z}wd*\bar{U}as-3*N1^{2}*\bar{Z}3*Rd*\bar{Z}2*\bar{U}cs+6*\bar{Z}bs*\bar{Z}1*N3^{2}*\bar{Z}wd*\bar{U}bs+\\
&3*\bar{Z}bs*\bar{Z}1*N3^{2}*Rd*\bar{U}cs+3*\bar{Z}bs*\bar{Z}1*N3^{2}*\bar{Z}bd*\bar{U}cs+3*\bar{Z}bs*\bar{Z}1*N3^{2}*Rd*\bar{U}bs+\\
&3*\bar{Z}bs*\bar{Z}1*N3^{2}*Rd*\bar{U}as+18*\bar{Z}bs*N1^{2}*\bar{Z}3*\bar{Z}wd*\bar{U}as+3*\bar{Z}bs*N1^{2}*\bar{U}as*Rd*\bar{Z}bd-\\
&6*N1^{2}*\bar{Z}3*\bar{Z}wd*\bar{Z}ws*\bar{U}cs+6*\bar{Z}bs*N1^{2}*\bar{U}as*Rd*\bar{Z}wd+9*\bar{Z}bs*N1^{2}*\bar{Z}3*Rd*\bar{U}as+\\
&9*\bar{Z}bs*N1^{2}*\bar{Z}3*\bar{Z}bd*\bar{U}as-3*\bar{Z}1*N2^{2}*\bar{U}cs*Rd*\bar{Z}3+12*\bar{Z}1*N2^{2}*\bar{U}as*\bar{Z}wd*\bar{Z}3-\\
&3*\bar{Z}1*N2^{2}*\bar{U}cs*\bar{Z}bd*\bar{Z}3-6*\bar{Z}1*N2^{2}*\bar{U}cs*\bar{Z}wd*\bar{Z}3+2*\bar{Z}1*N2^{2}*\bar{U}as*Rd*\bar{Z}bd+\\
&4*\bar{Z}1*N2^{2}*\bar{U}as*Rd*\bar{Z}wd+6*\bar{Z}1*N2^{2}*\bar{U}as*\bar{Z}bd*\bar{Z}3-\bar{Z}1*N2^{2}*\bar{U}cs*Rd*\bar{Z}bd-\\
&2*\bar{Z}1*N2^{2}*\bar{U}cs*Rd*\bar{Z}wd-3*\bar{Z}1*N2^{2}*\bar{U}bs*Rd*\bar{Z}3-N1^{2}*\bar{Z}ws*\bar{U}bs*Rd*\bar{Z}bd-\\
&6*N1^{2}*\bar{Z}3*\bar{Z}wd*\bar{Z}2*\bar{U}bs-2*N1^{2}*\bar{Z}ws*\bar{U}bs*Rd*\bar{Z}wd+6*\bar{Z}1*N2^{2}*\bar{U}as*Rd*\bar{Z}3+\\
&12*N1^{2}*\bar{Z}3*\bar{Z}wd*\bar{Z}2*\bar{U}as-6*\bar{Z}1*N2^{2}*\bar{U}bs*\bar{Z}wd*\bar{Z}3-2*\bar{Z}1*N2^{2}*\bar{U}bs*Rd*\bar{Z}wd-\\
&3*\bar{Z}1*N2^{2}*\bar{U}bs*\bar{Z}bd*\bar{Z}3-2*N1^{2}*\bar{Z}ws*\bar{U}cs*Rd*\bar{Z}wd+2*N1^{2}*\bar{Z}2*\bar{U}as*Rd*\bar{Z}bd+\\
&4*N1^{2}*\bar{Z}2*\bar{U}as*Rd*\bar{Z}wd-\bar{Z}1*N2^{2}*\bar{U}bs*Rd*\bar{Z}bd-N1^{2}*\bar{Z}ws*\bar{U}cs*Rd*\bar{Z}bd-\\
&3*N1^{2}*\bar{Z}3*\bar{Z}bd*\bar{Z}ws*\bar{U}bs-N1^{2}*\bar{Z}2*\bar{U}bs*Rd*\bar{Z}bd-2*N1^{2}*\bar{Z}2*\bar{U}bs*Rd*\bar{Z}wd+\\
&2*N1^{2}*\bar{Z}ws*\bar{U}as*Rd*\bar{Z}bd+4*N1^{2}*\bar{Z}ws*\bar{U}as*Rd*\bar{Z}wd-3*N1^{2}*\bar{Z}3*\bar{Z}bd*\bar{Z}2*\bar{U}cs+\\
&6*N1^{2}*\bar{Z}3*\bar{Z}bd*\bar{Z}ws*\bar{U}as)/N1/\bar{Z}bs/N2/(6*\bar{Z}wd*\bar{Z}3+3*\bar{Z}bd*\bar{Z}3+2*Rd*\bar{Z}wd+\\
&Rd*\bar{Z}bd+3*Rd*\bar{Z}3)
\end{aligned}
$$

(Eq. 29) $\overline{U}bp =$

$$
\begin{aligned}
-1/3*(&3*N1^{2}*\overline{Z}3*Rd*\overline{Z}ws*\overline{U}cs+3*N1^{2}*\overline{Z}3*Rd*\overline{Z}2*\overline{U}as-6*N1^{2}*\overline{Z}3*Rd*\overline{Z}2*\overline{U}bs-\\
&6*N1^{2}*\overline{Z}3*\overline{Z}bd*\overline{Z}2*\overline{U}bs+3*N1^{2}*\overline{Z}3*\overline{Z}bd*\overline{Z}ws*\overline{U}cs+6*N1^{2}*\overline{Z}3*\overline{Z}wd*\overline{Z}2*\overline{U}cs+\\
&6*N1^{2}*\overline{Z}3*\overline{Z}wd*\overline{Z}ws*\overline{U}as-12*N1^{2}*\overline{Z}3*\overline{Z}wd*\overline{Z}ws*\overline{U}bs+\\
&3*N1^{2}*\overline{Z}3*\overline{Z}bd*\overline{Z}2*\overline{U}as-3*\overline{Z}bs*\overline{Z}1*N3^{2}*\overline{Z}bd*\overline{U}as+3*N1^{2}*\overline{Z}3*Rd*\overline{Z}ws*\overline{U}as-\\
&6*N1^{2}*\overline{Z}3*Rd*\overline{Z}ws*\overline{U}bs+N1^{2}*\overline{Z}2*\overline{U}cs*Rd*\overline{Z}bd+2*N1^{2}*\overline{Z}2*\overline{U}cs*Rd*\overline{Z}wd-\\
&3*\overline{Z}bs*\overline{Z}1*N3^{2}*\overline{Z}bd*\overline{U}bs-6*\overline{Z}bs*\overline{Z}1*N3^{2}*\overline{Z}wd*\overline{U}cs-6*\overline{Z}bs*\overline{Z}1*N3^{2}*\overline{Z}wd*\overline{U}as+\\
&3*N1^{2}*\overline{Z}3*Rd*\overline{Z}2*\overline{U}cs-6*\overline{Z}bs*\overline{Z}1*N3^{2}*\overline{Z}wd*\overline{U}bs-3*\overline{Z}bs*\overline{Z}1*N3^{2}*Rd*\overline{U}cs-\\
&3*\overline{Z}bs*\overline{Z}1*N3^{2}*\overline{Z}bd*\overline{U}cs-3*\overline{Z}bs*\overline{Z}1*N3^{2}*Rd*\overline{U}bs-3*\overline{Z}bs*\overline{Z}1*N3^{2}*Rd*\overline{U}as+\\
&6*N1^{2}*\overline{Z}3*\overline{Z}wd*\overline{Z}ws*\overline{U}cs+3*\overline{Z}1*N2^{2}*\overline{U}cs*Rd*\overline{Z}3+6*\overline{Z}1*N2^{2}*\overline{U}as*\overline{Z}wd*\overline{Z}3+\\
&3*\overline{Z}1*N2^{2}*\overline{U}cs*\overline{Z}bd*\overline{Z}3+6*\overline{Z}1*N2^{2}*\overline{U}cs*\overline{Z}wd*\overline{Z}3+\overline{Z}1*N2^{2}*\overline{U}as*Rd*\overline{Z}bd+\\
&2*\overline{Z}1*N2^{2}*\overline{U}as*Rd*\overline{Z}wd+3*\overline{Z}1*N2^{2}*\overline{U}as*\overline{Z}bd*\overline{Z}3+\overline{Z}1*N2^{2}*\overline{U}cs*Rd*\overline{Z}bd+\\[6pt]
&2*\overline{Z}1*N2^{2}*\overline{U}cs*Rd*\overline{Z}wd-6*\overline{Z}1*N2^{2}*\overline{U}bs*Rd*\overline{Z}3-2*N1^{2}*\overline{Z}ws*\overline{U}bs*Rd*\overline{Z}bd-\\
&12*N1^{2}*\overline{Z}3*\overline{Z}wd*\overline{Z}2*\overline{U}bs-4*N1^{2}*\overline{Z}ws*\overline{U}bs*Rd*\overline{Z}wd+3*\overline{Z}1*N2^{2}*\overline{U}as*Rd*\overline{Z}3+\\
&6*N1^{2}*\overline{Z}3*\overline{Z}wd*\overline{Z}2*\overline{U}as-12*\overline{Z}1*N2^{2}*\overline{U}bs*\overline{Z}wd*\overline{Z}3-4*\overline{Z}1*N2^{2}*\overline{U}bs*Rd*\overline{Z}wd-\\
&6*\overline{Z}1*N2^{2}*\overline{U}bs*\overline{Z}bd*\overline{Z}3+2*N1^{2}*\overline{Z}ws*\overline{U}cs*Rd*\overline{Z}wd+N1^{2}*\overline{Z}2*\overline{U}as*Rd*\overline{Z}bd+\\
&2*N1^{2}*\overline{Z}2*\overline{U}as*Rd*\overline{Z}wd-2*\overline{Z}1*N2^{2}*\overline{U}bs*Rd*\overline{Z}bd-9*N1^{2}*\overline{Z}bs*\overline{Z}3*Rd*\overline{U}bs-\\
&9*N1^{2}*\overline{Z}bs*\overline{Z}3*\overline{Z}bd*\overline{U}bs-6*N1^{2}*\overline{U}bs*\overline{Z}bs*Rd*\overline{Z}wd-3*N1^{2}*\overline{U}bs*\overline{Z}bs*Rd*\overline{Z}bd-\\
&18*N1^{2}*\overline{Z}bs*\overline{Z}3*\overline{Z}wd*\overline{U}bs+N1^{2}*\overline{Z}ws*\overline{U}cs*Rd*\overline{Z}bd-6*N1^{2}*\overline{Z}3*\overline{Z}bd*\overline{Z}ws*\overline{U}bs-\\
&2*N1^{2}*\overline{Z}2*\overline{U}bs*Rd*\overline{Z}bd-4*N1^{2}*\overline{Z}2*\overline{U}bs*Rd*\overline{Z}wd+N1^{2}*\overline{Z}ws*\overline{U}as*Rd*\overline{Z}bd+\\
&2*N1^{2}*\overline{Z}ws*\overline{U}as*Rd*\overline{Z}wd+3*N1^{2}*\overline{Z}3*\overline{Z}bd*\overline{Z}2*\overline{U}cs+3*N1^{2}*\overline{Z}3*\overline{Z}bd*\overline{Z}ws*\overline{U}as)/\\
&N1/\overline{Z}bs/N2/(6*\overline{Z}wd*\overline{Z}3+3*\overline{Z}bd*\overline{Z}3+2*Rd*\overline{Z}wd+Rd*\overline{Z}bd+3*Rd*\overline{Z}3)
\end{aligned}
$$

(Eq. 30) $\overline{U}cp =$

$-1/3*(-6*N1^{2*}\overline{Z}3*Rd*\overline{Z}ws*\overline{U}cs+3*N1^{2*}\overline{Z}3*Rd*\overline{Z}2*\overline{U}as+$
$3*N1^{2*}\overline{Z}3*Rd*\overline{Z}2*\overline{U}bs+3*N1^{2*}\overline{Z}3*\overline{Z}bd*\overline{Z}2*\overline{U}bs-6*N1^{2*}\overline{Z}3*\overline{Z}bd*\overline{Z}ws*\overline{U}cs-$
$12*N1^{2*}\overline{Z}3*\overline{Z}wd*\overline{Z}2*\overline{U}cs+6*N1^{2*}\overline{Z}3*\overline{Z}wd*\overline{Z}ws*\overline{U}as+$
$6*N1^{2*}\overline{Z}3*\overline{Z}wd*\overline{Z}ws*\overline{U}bs+3*N1^{2*}\overline{Z}3*\overline{Z}bd*\overline{Z}2*\overline{U}as-3*\overline{Z}bs*\overline{Z}1*N3^{2*}\overline{Z}bd*\overline{U}as+$
$3*N1^{2*}\overline{Z}3*Rd*\overline{Z}ws*\overline{U}as+3*N1^{2*}\overline{Z}3*Rd*\overline{Z}ws*\overline{U}bs-2*N1^{2*}\overline{Z}2*\overline{U}cs*Rd*\overline{Z}bd-$
$4*N1^{2*}\overline{Z}2*\overline{U}cs*Rd*\overline{Z}wd-3*\overline{Z}bs*\overline{Z}1*N3^{2*}\overline{Z}bd*\overline{U}bs-6*\overline{Z}bs*\overline{Z}1*N3^{2*}\overline{Z}wd*\overline{U}cs-$
$6*\overline{Z}bs*\overline{Z}1*N3^{2*}\overline{Z}wd*\overline{U}as-6*N1^{2*}\overline{Z}3*Rd*\overline{Z}2*\overline{U}cs-6*\overline{Z}bs*\overline{Z}1*N3^{2*}\overline{Z}wd*\overline{U}bs-$
$3*\overline{Z}bs*\overline{Z}1*N3^{2*}Rd*\overline{U}cs-3*\overline{Z}bs*\overline{Z}1*N3^{2*}\overline{Z}bd*\overline{U}cs-3*\overline{Z}bs*\overline{Z}1*N3^{2*}Rd*\overline{U}bs-$
$3*\overline{Z}bs*\overline{Z}1*N3^{2*}Rd*\overline{U}as-12*N1^{2*}\overline{Z}3*\overline{Z}wd*\overline{Z}ws*\overline{U}cs-6*\overline{Z}1*N2^{2*}\overline{U}cs*Rd*\overline{Z}3+$
$6*\overline{Z}1*N2^{2*}\overline{U}as*\overline{Z}wd*\overline{Z}3-6*\overline{Z}1*N2^{2*}\overline{U}cs*\overline{Z}bd*\overline{Z}3-12*\overline{Z}1*N2^{2*}\overline{U}cs*\overline{Z}wd*\overline{Z}3+$
$\overline{Z}1*N2^{2*}\overline{U}as*Rd*\overline{Z}bd+2*\overline{Z}1*N2^{2*}\overline{U}as*Rd*\overline{Z}wd+3*\overline{Z}1*N2^{2*}\overline{U}as*\overline{Z}bd*\overline{Z}3-$
$2*\overline{Z}1*N2^{2*}\overline{U}cs*Rd*\overline{Z}bd-4*\overline{Z}1*N2^{2*}\overline{U}cs*Rd*\overline{Z}wd+3*\overline{Z}1*N2^{2*}\overline{U}bs*Rd*\overline{Z}3+$
$N1^{2*}\overline{Z}ws*\overline{U}bs*Rd*\overline{Z}bd+6*N1^{2*}\overline{Z}3*\overline{Z}wd*\overline{Z}2*\overline{U}bs+2*N1^{2*}\overline{Z}ws*\overline{U}bs*Rd*\overline{Z}wd+$
$3*\overline{Z}1*N2^{2*}\overline{U}as*Rd*\overline{Z}3+6*N1^{2*}\overline{Z}3*\overline{Z}wd*\overline{Z}2*\overline{U}as+6*\overline{Z}1*N2^{2*}\overline{U}bs*\overline{Z}wd*\overline{Z}3+$
$2*\overline{Z}1*N2^{2*}\overline{U}bs*Rd*\overline{Z}wd+3*\overline{Z}1*N2^{2*}\overline{U}bs*\overline{Z}bd*\overline{Z}3-4*N1^{2*}\overline{Z}ws*\overline{U}cs*Rd*\overline{Z}wd+$
$N1^{2*}\overline{Z}2*\overline{U}as*Rd*\overline{Z}bd+2*N1^{2*}\overline{Z}2*\overline{U}as*Rd*\overline{Z}wd+\overline{Z}1*N2^{2*}\overline{U}bs*Rd*\overline{Z}bd-$
$2*N1^{2*}\overline{Z}ws*\overline{U}cs*Rd*\overline{Z}bd+3*N1^{2*}\overline{Z}3*\overline{Z}bd*\overline{Z}ws*\overline{U}bs+N1^{2*}\overline{Z}2*\overline{U}bs*Rd*\overline{Z}bd+$
$2*N1^{2*}\overline{Z}2*\overline{U}bs*Rd*\overline{Z}wd+N1^{2*}\overline{Z}ws*\overline{U}as*Rd*\overline{Z}bd+2*N1^{2*}\overline{Z}ws*\overline{U}as*Rd*\overline{Z}wd-$
$6*N1^{2*}\overline{Z}3*\overline{Z}bd*\overline{Z}2*\overline{U}cs+3*N1^{2*}\overline{Z}3*\overline{Z}bd*\overline{Z}ws*\overline{U}as-18*N1^{2*}\overline{Z}bs*\overline{Z}3*\overline{Z}wd*\overline{U}cs-$
$9*N1^{2*}\overline{Z}bs*\overline{Z}3*\overline{Z}bd*\overline{U}cs-6*N1^{2*}\overline{Z}bs*\overline{U}cs*Rd*\overline{Z}wd-3*N1^{2*}\overline{Z}bs*\overline{U}cs*Rd*\overline{Z}bd-$
$9*N1^{2*}\overline{Z}bs*\overline{Z}3*Rd*\overline{U}cs)/N1/\overline{Z}bs/N2/(6*\overline{Z}wd*\overline{Z}3+3*\overline{Z}bd*\overline{Z}3+2*Rd*\overline{Z}wd+$
$Rd*\overline{Z}bd+3*Rd*\overline{Z}3)$

As can be seen from the above equations for $\overline{U}ap$, $\overline{U}bp$ and $\overline{U}cp$, in order to calculate primary phase-to-earth voltages from measured secondary voltages $\overline{U}as$, $\overline{U}bs$ and $\overline{U}cs$, e.g. the values of the following parameters may be needed:

parameters of the voltage transformers comprising:

$\overline{Z}1$ = Impedance of the primary winding
$\overline{Z}2$ = Impedance of the secondary winding
$\overline{Z}3$ = Impedance of the tertiary winding

parameters of the circuit connected to the secondary windings comprising:

$\overline{Z}ws$ = Wiring impedance of the secondary circuit
$\overline{Z}wn$ = Wiring impedance of the secondary circuit, neutral conductor
$\overline{Z}bs$ = Secondary burden impedance

and parameters of the circuit connected to the tertiary windings comprising:

$\overline{Z}wd$ = Wiring impedance of the open delta
$\overline{Z}bd$ = Tertiary burden impedance
Rd = Ferroresonance (tertiary) damping resistance

Parameter Rd, the resistance of a ferro-resonance damping resistor, value is typically known. This is because it is a separate component and it is dimensioned when ordered. However, one or more values of the impedance parameters are often not known.

According to an embodiment, the determining of values of impedance parameters related to a transformer configuration, such as the one in Figure 3, the primary windings 21, 22 and 23 of which are connected to the phases PA, PB and PC of a three phase electric system, comprises: conducting an earth fault in the three phase electric system by connecting one of the phases PA, PB or PC of the three phase electric system to earth; measuring a primary voltage from the faulted phase; measuring secondary voltages from the secondary windings 41, 42, 43; and determining values of one or more impedance parameters related to the transformer configuration on the basis of the measured primary voltage, the measured secondary voltages and an equation relating the primary voltage to the secondary voltages and the one or more impedance parameters related to the transformer configuration

In case only one impedance parameter value is unknown, then it can be calculated directly on the basis of one of the equations 25 to 30. In case two or more impedance parameter values are unknown, an iterative procedure may be used to determine the values. According to an embodiment, when the number of the impedance parameters whose values are to be determined is two or more, the determining above comprises: finding by iteration such values of the two or more impedance parameters related to the transformer configuration that minimize a difference between the measured value of the primary voltage and a calculated value of the primary voltage obtained on the basis of the equation, the measured secondary voltages and the values of the two or more impedance parameters; and selecting the found values as the determined values of the two or more impedance parameters related to the transformer configuration. In the following, a more detailed example of how the values of the impedance parameters can be determined is given:

First, a trial earth fault is conducted by connecting one of the phases PA, PB or PC of the three phase electric system to earth. It is preferable to include some fault resistance in the fault current path so that the amplitude of the faulted phase voltage stays greater than zero. A value of few hundreds of volts (in a 20 kV system) is suggested. A primary voltage $\overline{U}ap$, $\overline{U}bp$ or $\overline{U}cp$ measurement from the faulted phase is made using e.g. a voltage sensor, which can be installed temporarily or be a part of movable test equipment, for example. The voltage sensor is preferably based on a resistive divider. Voltage from the sensor may be phase angle and magnitude corrected, if applicable and suggested by the sensor manufacturer. Secondary voltages $\overline{U}s$, $\overline{U}bs$ and $\overline{U}cs$ from the secondary windings 41, 42, 43 of the voltage transformers 11, 12, 13 are measured and recorded by e.g. corresponding IEDs (Intelligent Electronic Device) of the substation, and the primary voltage from the sensor is recorded by e.g. a dedicated IED, which can be a part of movable test equipment. Recordings are preferably synchronized in order to make the evaluation of phase displacement possible. Also an oscilloscope can be used for the recording, especially when the number of the measured three-phase voltage sets is limited, e.g. a voltage transformer measurement from only one IED of the station is selected for use in the optimization procedure. Alternatively, the optimization procedure can be conducted for each IED of the substation by using the corresponding recordings from these IEDs. The primary voltage from the voltage sensor is then used as a reference and as the "true" voltage of the electric system. Both the measured primary voltage $\overline{U}ap$, $\overline{U}bp$ or $\overline{U}cp$ and the voltage transformer voltages $\overline{U}as$, $\overline{U}bs$ and $\overline{U}cs$ are preferably transformed into a phasor form, e.g. by using DFT-algorithm (Discrete Fourier Transform). It should be noted that the primary voltage may be measured using other means than a voltage sensor. In fact, any sufficiently accurate way of measuring may be utilized. Thus, the invention is not limited to the use of a voltage sensor in the measurement of the primary voltage.

Next, an iterative optimization procedure is conducted, where one of equations 25-30 (or generally any other equation relating the primary voltage to the secondary voltages and the one or more impedance parameters related to the transformer configuration) is utilized. The equation to be used is the applicable phase voltage equation 25-30 that matches the faulted phase of the trial earth fault, i.e. equation 25 or 28 for a trial earth fault in phase PA, equation 26 or 29 for a trial earth fault in phase PB and equation 27 or 29 for a trial earth fault in phase PC. An iterative optimization procedure finds values for two or more of the following parameters:

$\overline{Z}1$ = Impedance of the primary winding
$\overline{Z}2$ = Impedance of the secondary winding
$\overline{Z}3$ = Impedance of the tertiary winding
$\overline{Z}ws$ = Secondary wiring impedance
$\overline{Z}wn$ = Wiring impedance of the neutral conductor of the secondary burden
$\overline{Z}wd$ = Tertiary wiring impedance
$\overline{Z}bs$ = Secondary burden impedance
$\overline{Z}bd$ = Tertiary burden impedance

by minimizing the error: error = $\overline{U}xp\_meas - \overline{U}xp\_calc$, where x is the faulted phase in the trial earth fault. $\overline{U}xp\_meas$ is the measured primary voltage of the faulted phase and $\overline{U}xp\_calc$ is the calculated primary voltage of the faulted phase calculated with the applicable equation 25-30. The optimization algorithm should be able to handle multiple variables and preferable constrains such that the obtained parameter set is realistic, e.g. impedances have positive values. As the optimization is an iterative process, initial guess for parameters could be based on the best knowledge of the system. Preferably a parameter set is accepted, which minimizes the error between sensor and voltage transformer measurement. Theoretically this is a parameter set, which gives:

$$\text{error} = \overline{U}\text{xp\_meas} - \overline{U}\text{xp\_calc} = 0$$

The applied optimization method can be any known algorithm capable in multivariable optimization, e.g. Nelder-Mead algorithm. The Nelder-Mead method is a "simplex" method for finding a local minimum of a function of several variables. It is effective and computationally compact. This function can be found from popular math programs, such as Matlab® or GNU Octave. The algorithm is available in Matlab® and GNU Octave as a function called fminsearch. The source code is also available to be ported into an IED or other platform, for example. The optimization thus preferably minimizes the difference between the measured primary voltage and the calculated value of the primary voltage and returns the corresponding values for the optimized parameters, which provide the minimum.

It should be noted that all the above listed impedance parameters, or just selected ones, can be determined by the optimization procedure. All the other parameters are then fixed as predetermined values. Thus, impedance parameters with predetermined values act as constants in the optimization procedure.

According to an embodiment, the above determination of the parameter values is repeated for all three phases PA, PB and PC. In other words, the trial earth fault is conducted in each of the three phases and the values of the one or more impedance parameters are determined separately for each phase using the corresponding equation 25-30. A benefit of determining separate parameter values for all three earth fault conditions is that the obtained parameters are more accurate and take into account better e.g. possible asymmetry in the three phase system.

According to an embodiment, the obtained values of the impedance parameters are then used in equations 25-30 or corresponding equations in order to compensate for the errors of the voltage transformers when determining the primary voltage $\overline{U}$ap, $\overline{U}$bp or $\overline{U}$cp on the basis of measured secondary voltages $\overline{U}$as, $\overline{U}$bs and $\overline{U}$cs. In other words, the primary voltages can be calculated using equations 25-30, measured secondary voltages $\overline{U}$as, $\overline{U}$bs and $\overline{U}$cs and the determined values of the impedance parameters. If the determination of the impedance parameter values is repeated for all three phases PA, PB and PC, then the parameter values to be used in each case are preferably selected such that for an earth fault in phase PA, PB or PC the impedance parameter values determined during a trial earth fault in the same phase are used. For example, if an earth fault occurs in phase PA, then preferably impedance parameter values determined during a trial earth fault in phase PA are used in equation 25-30 for the calculation of one or more primary voltages. If the determination of the impedance parameter values is performed for only one phase PA, PB or PC, then the parameter values thus obtained may be used during an earth fault in any of the phases PA, PB or PC.

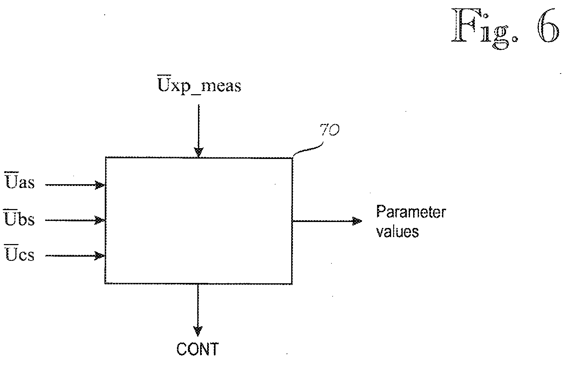

An apparatus according to any one of the above embodiments, or a combination thereof, may be implemented as one unit or as two or more separate units that are configured to implement the functionality of the various embodiments. Here the term 'unit' refers generally to a physical or logical entity, such as a physical device or a part thereof or a software routine. Figure 6 illustrates an example of a device 70 that receives as inputs primary voltage $\overline{U}$xp_meas and secondary voltages $\overline{U}$as, $\overline{U}$bs, $\overline{U}$cs measured during the trial earth fault and determines and outputs the values of the impedance parameters to be determined as described above, for example. Impedance parameter values that are predetermined may be stored in the device 70. The device 70 may also comprise means for conducting the trial earth fault such as a control output CONT for controlling a switching device. The device 70 may also comprise a suitable user interface.

An apparatus according to any one of the embodiments may be implemented by means of a computer or corresponding digital signal processing equipment provided with suitable software, for example. Such a computer or digital signal processing equipment preferably comprises at least a working memory (RAM) providing storage area for arithmetical operations and a central processing unit (CPU), such as a general-purpose digital signal processor. The CPU may comprise a set of registers, an arithmetic logic unit, and a control unit. The control unit is controlled by a sequence of program instructions transferred to the CPU from the RAM. The control unit may contain a number of microinstructions for basic operations. The implementation of microinstructions may vary depending on the CPU design. The program instructions may be coded by a programming language, which may be a high-level programming language, such as C, Java, etc., or a low-level programming language, such as a machine language, or an assembler. The computer may also have an operating system which may provide system services to a computer program written with the program instructions. The computer or another apparatus implementing the invention further preferably comprises suitable input means and output means. It is also possible to use a specific integrated circuit or circuits, and/or discrete components and devices for implementing the functionality according to any one of the embodiments.

The invention can be implemented in existing system elements, such as one or more IEDs, or by using separate dedicated elements or devices in a centralized or distributed manner. Present devices, such as IEDs, for electric systems may comprise processors and memory that can be utilized in the functions according to embodiments of the invention.

Thus, all modifications and configurations required for implementing an embodiment of the invention e.g. in existing devices may be performed as software routines, which may be implemented as added or updated software routines. If the functionality of the invention is implemented by software, such software can be provided as a computer program product comprising computer program code which, when run on a computer, causes the computer or a corresponding arrangement to perform the functionality according to the invention, as described above. Such a computer program code may be stored or generally embodied on a computer readable medium, such as suitable memory, e.g. a flash memory or a disc memory from which it is loadable to the unit or units executing the program code. In addition, such a computer program code implementing the invention may be loaded to the unit or units executing the computer program code via a suitable data network, for example, and it may replace or update a possibly existing program code.

It will be obvious to a person skilled in the art that, as the technology advances, the inventive concept can be implemented in various ways. The invention and its embodiments are not limited to the examples described above but may vary within the scope of the claims.

**Claims**

1. A method for determining values of impedance parameters related to a transformer configuration comprising three single pole voltage transformers (11, 12, 13) each having at least a primary winding (21, 22, 23), a secondary winding (41, 42, 43) and a tertiary winding (31, 32, 33), wherein the primary windings are connected to phases (PA, PB, PC) of a three phase electric system and the tertiary windings of the voltage transformers are open-delta connected with each other, wherein the method comprises:

   a) conducting an earth fault in the three phase electric system by connecting to earth one of the phases (PA, PB, PC) of the three phase electric system;
   b) measuring a primary voltage from the faulted phase;
   c) measuring secondary voltages from the secondary windings (41, 42, 43); and
   d) determining values of one or more impedance parameters related to the transformer configuration using the measured primary voltage, the measured secondary voltages and an equation relating the primary voltage to the secondary voltages and the one or more impedance parameters related to the transformer configuration.

2. A method as claimed in claim 1, **characterized in that**, when the number of the impedance parameters whose values are determined is two or more, step d) comprises:

   finding by iteration such values of the two or more impedance parameters related to the transformer configuration that minimize a difference between the measured value of the primary voltage and a calculated value of the primary voltage obtained using the equation, the measured secondary voltages and the values of the two or more impedance parameters; and
   selecting the found values as the determined values of the two or more impedance parameters related to the transformer configuration.

3. A method as claimed in claim 1 or 2, c**haracterized** in that steps a) to d) are performed for all three phases (PA, PB, PC).

4. A method as claimed in claim 1, 2 or 3, **characterized in that** the impedance parameters related to the transformer configuration comprise one or more impedance parameters of the voltage transformers (11, 12, 13), one or more impedance parameters of a circuit connected to the secondary windings (41, 42, 43) and/or one or more impedance parameters of a circuit connected to the tertiary windings (31, 32, 33).

5. A method as claimed in claim 4, **characterized in that** the impedance parameters of the voltage transformers (11, 12, 13) comprise an impedance of the primary winding (21, 22, 23), an impedance of the secondary winding (41, 42, 43) and/or an impedance of the tertiary winding (31, 32, 33).

6. A method as claimed in claim 4 or 5, **characterized in that** the impedance parameters of the circuit connected to the secondary windings (41, 42, 43) comprise a secondary burden impedance and/or a secondary wiring impedance.

7. A method as claimed in claim 6, **characterized in that** the impedance parameters of the circuit connected to the secondary windings (41, 42, 43) comprise a secondary neutral conductor impedance when the secondary burden impedances are star-connected.

8. A method as claimed in any one of claims 4-7, **characterized in that** the impedance parameters of the circuit connected to the tertiary windings (31, 32, 33) comprise a tertiary burden impedance and/or a tertiary wiring impedance.

9. An arrangement for determining values of impedance parameters related to a transformer configuration comprising three single pole voltage transformers (11, 12, 13) each having at least a primary winding (21, 22, 23), a secondary winding (41, 42, 43) and a tertiary winding (31, 32, 33), wherein the primary windings are connected to phases (PA, PB, PC) of a three phase electric system and the tertiary windings of the voltage transformers are open-delta connected with each other, wherein the arrangement comprises:

   means (70) for conducting an earth fault in the three phase electric system by connecting to earth one of the phases (PA, PB, PC) of the three phase electric system;
   means (70) for measuring a primary voltage from the faulted phase;
   means (70) for measuring secondary voltages from the secondary windings (41, 42, 43); and
   means (70) for determining values of one or more impedance parameters related to the transformer configuration using the measured primary voltage, the measured secondary voltages and an equation relating the primary voltage to the secondary voltages and the one or more impedance parameters related to the transformer configuration.

10. An arrangement as claimed in claim 9, **characterized in that**, when the number of the impedance parameters whose values are to be determined is two or more, the means (70) for determining comprises means for
finding by iteration such values of the two or more impedance parameters related to the transformer configuration that minimize a difference between the measured value of the primary voltage and a calculated value of the primary voltage obtained using the equation, the measured secondary voltages and the values of the two or more impedance parameters; and
selecting the found values as the determined values of the one or more impedance parameters related to the transformer configuration.

11. An arrangement as claimed in claim 9 or 10, **characterized in that** the impedance parameters related to the transformer configuration comprise one or more impedance parameters of the voltage transformers (11, 12, 13), one or more impedance parameters of a circuit connected to the secondary windings (41, 42, 43) and/or one or more impedance parameters of a circuit connected to the tertiary windings (31, 32, 33).

12. An arrangement as claimed in claim 11, **characterized in that** the impedance parameters of the voltage transformers (11, 12, 13) comprise an impedance of the primary winding (21, 22, 23), an impedance of the secondary winding (41, 42, 43) and/or an impedance of the tertiary winding (31, 32, 33).

13. An arrangement as claimed in claim 11 or 12, **characterized in that** the impedance parameters of the circuit connected to the secondary windings (41, 42, 43) comprise a secondary burden impedance and/or a secondary wiring impedance.

14. An arrangement as claimed in claim 13, **characterized in that** the impedance parameters of the circuit connected to the secondary windings (41, 42, 43) comprise a secondary neutral conductor impedance when the secondary burden impedances are star-connected.

15. An arrangement as claimed in any one of claims 11-14, **characterized in that** the impedance parameters of the circuit connected to the tertiary windings (31, 32, 33) comprise a tertiary burden impedance and/or a tertiary wiring impedance.

**Patentansprüche**

1. Eine Methode zur Ermittlung der Werte von Impedanzparametern, in Verbindung mit einer Transformatorkonfiguration, bestehend aus drei einpoligen Spannungswandlern (11, 12, 13), die jeder mindestens eine Primärwicklung (21, 22, 23), eine Sekundärwicklung (41, 42, 43) und eine Tertiärwicklung (31, 32, 33) enthalten, wobei die Primärwicklungen mit den Phasen (PA, PB, PC) eines Drei- Phasen- Elektrosystems verbunden sind und die Tertiärwicklungen des Spannungswandlers miteinander in einem offenen Dreieck geschaltet sind, wobei die Methode umfasst:

a) Herstellung eines Erdschlusses in dem Drei- Phasen-Elektrosystem durch Verbindung einer der Phasen (PA, PB, PC) des Drei- Phasen- Elektrosystems mit der Erde.

b) Messung einer Primärspannung an der erdschlussbehafteten Phase;

c) Messung der Sekundärspannungen an den Sekundärwicklungen (41, 42, 43); und

d) Bestimmung der Werte eines oder mehrerer Impedanzparameter in Verbindung mit der Transformatorkonfiguration, unter Verwendung der gemessenen Primärspannung, der gemessenen Sekundärspannungen und einer Gleichung, die die Primärspannung mit den Sekundärspannungen und dem einen oder dem mehreren Impedanzparametern, die mit der Transformatorkonfiguration zusammenhängen, in Verbindung setzt.

2. Eine Methode wie beansprucht in Anspruch 1, **dadurch gekennzeichnet, dass** wenn die Zahl der Impedanzparameter, deren Werte ermittelt werden, zwei oder höher ist, Schritt d) umfasst:

durch Iteration solche Werte der zwei oder mehr Impedanzparameter, in Zusammenhang mit der Transformatorkonfiguration herauszufinden, die die Differenz zwischen dem gemessenen Wert der Primärspannung und dem berechneten Wert der Primärspannung, der sich bei Verwendung der Gleichung ergibt, den gemessenen Sekundärspannungen und den Werten der zwei oder mehr Impedanzparameter minimieren; und
Auswahl der gefundenen Werte als die ermittelten Werte der zwei oder mehr Impedanzparameter in Zusammenhang mit der Transformatorkonfiguration.

3. Eine Methode wie beansprucht in Anspruch 1 oder 2, **dadurch gekennzeichnet, dass** die Schritte a) bis d) für alle drei Phasen (PA, PB, PC) durchgeführt werden.

4. Eine Methode wie beansprucht in Anspruch 1, 2 oder 3, **dadurch gekennzeichnet, dass** die Impedanzparameter in Zusammenhang mit der Transformatorkonfiguration einen oder mehrere Impedanzparameter der Spannungswandler (11, 12, 13), einen oder mehrere Impedanzparameter eines Stromkreises, der mit den Sekundärwicklungen (41, 42, 43) verbunden ist und/ oder einen oder mehrere Impedanzparameter eines Stromkreises, der mit den Tertiärwicklung (31, 32, 33) verbunden ist, umfassen.

5. Eine Methode wie beansprucht in Anspruch 4, **dadurch gekennzeichnet, dass** die Impedanzparameter der Spannungswandler (11, 12, 13), eine Impedanz der Primärwicklung (21, 22, 23), eine Impedanz der Sekundärwicklung (41, 42, 43) und/oder eine Impedanz der Tertiärwicklung (31, 32, 33) umfassen.

6. Eine Methode wie beansprucht in Anspruch 4 oder 5, **dadurch gekennzeichnet, dass** die Impedanzparameter des mit den Sekundärwicklungen (41, 42, 43) verbundenen Stromkreises eine sekundäre Lastimpedanz und/oder eine sekundäre Wicklungsimpedanz umfassen.

7. Eine Methode wie beansprucht in Anspruch 6, **dadurch gekennzeichnet, dass** die Impedanzparameter des Stromkreises, der mit den Sekundärwicklungen (41, 42, 43) verbunden ist, eine sekundäre Nullleiter- Impedanz umfassen, wenn die sekundären Lastimpedanzen in einer Sternschaltung verbunden sind.

8. Eine Methode wie beansprucht in irgendeinem der Ansprüche 4- 7, **dadurch gekennzeichnet, dass** die Impedanzparameter des mit den Tertiärwicklungen (31, 32, 33) verbundenen Stromkreises eine dritte Lastimpedanz und/oder eine dritte Wicklungsimpedanz umfassen.

9. Eine Anordnung zur Ermittlung der Werte von Impedanzparametern, in Verbindung mit einer Transformatorkonfiguration, bestehend aus drei einpoligen Spannungswandlern (11, 12, 13), die jeder mindestens eine Primärwicklung (21, 22, 23), eine Sekundärwicklung (41, 42, 43) und eine Tertiärwicklung (31, 32, 33) enthalten, wobei die Primärwicklungen mit den Phasen (PA, PB, PC) eines DreiPhasen- Elektrosystems verbunden sind und die Tertiärwicklungen des Spannungswandlers miteinander im offenen Dreieck geschaltet sind, wobei die Anordnung umfasst:

Mittel (70) zur Herstellung eines Erdschlusses in dem DreiPhasen- Elektrosystem durch Verbindung einer der Phasen (PA, PB, PC) des Drei- Phasen- Elektrosystems mit der Erde;
Mittel (70) zur Messung einer Primärspannung an der erdschlussbehafteten Phase;
Mittel (70) Messung der Sekundärspannungen an den Sekundärwicklung (41, 42, 43); und
Mittel (70) zur Ermittlung der Werte eines oder mehrerer Impedanzparameter in Verbindung mit der Transformatorkonfiguration, unter Verwendung der gemessenen Primärspannung, der gemessenen Sekundärspannungen und einer Gleichung, die die Primärspannung mit den Sekundärspannungen und dem einen oder den mehreren Impedanzparametern, die mit der Transformatorkonfiguration zusammenhängen, in Verbindung setzt.

**10.** Eine Anordnung wie beansprucht in Anspruch 9, **dadurch gekennzeichnet, dass** wenn die Zahl der Impedanzparameter, deren Werte ermittelt werden sollen, zwei oder höher ist, die Mittel (70) zur Ermittlung auch Mittel umfassen, um durch Iteration solche Werte der zwei oder mehr Impedanzparameter in Zusammenhang mit der Transformatorkonfiguration herauszufinden, die die Differenz zwischen dem gemessenen Wert der Primärspannung und dem berechneten Wert der Primärspannung, der sich bei Verwendung der Gleichung ergibt, den gemessenen Werten der Sekundärspannungen und den Werten der zwei oder mehr Impedanzparameter, minimieren;
und
Auswahl der gefundenen Werte als die ermittelten Werte des einen oder der mehreren Impedanzparameter in Zusammenhang mit der Transformatorkonfiguration.

**11.** Eine Anordnung wie beansprucht in Anspruch 9 oder 10, **dadurch gekennzeichnet, dass** die Impedanzparameter in Zusammenhang mit der Transformatorkonfiguration einen oder mehrere Impedanzparameter der Spannungswandler (11, 12, 13), einen oder mehrere Impedanzparameter eines Stromkreises, der mit den Sekundärwicklungen (41, 42, 43) verbunden ist und/ oder einen oder mehrere Impedanzparameter eines Stromkreises, der mit den Tertiärwicklung (31, 32, 33) verbunden ist, umfassen.

**12.** Eine Anordnung wie beansprucht in Anspruch 11, **dadurch gekennzeichnet, dass** die Impedanzparameter der Spannungswandler (11, 12, 13), eine Impedanz der Primärwicklung (21, 22, 23), eine Impedanz der Sekundärwicklung (41, 42, 43) und/ oder eine Impedanz der Tertiärwicklung (31, 32, 33) umfassen.

**13.** Eine Anordnung wie beansprucht in Anspruch 11 oder 12, **dadurch gekennzeichnet, dass** die Impedanzparameter des mit den Sekundärwicklungen (41, 42, 43) verbundenen Stromkreises, eine sekundäre Lastimpedanz und/ oder eine sekundäre Wicklungsimpedanz umfassen.

**14.** Eine Anordnung wie beansprucht in Anspruch 13, **dadurch gekennzeichnet, dass** die Impedanzparameter des Stromkreises, der mit den Sekundärwicklungen (41, 42, 43) verbunden ist, eine sekundäre Nullleiterimpedanz umfasst, wenn die sekundären Lastimpedanzen als Sternschaltung verbunden sind.

**15.** Eine Anordnung wie beansprucht in irgendeinem der Ansprüche 11-14, **dadurch gekennzeichnet, dass** die Impedanzparameter des Stromkreises, der mit den Tertiärwicklungen (31, 32, 33) verbunden ist, eine tertiäre Lastimpedanz und/ oder eine tertiäre Wicklungsimpedanz umfassen.


**Revendications**

**1.** Procédé pour déterminer des valeurs de paramètres d'impédance liés à une configuration de transformateur comprenant trois transformateurs de tension monopolaires (11, 12, 13) ayant chacun au moins un enroulement primaire (21, 22, 23), un enroulement secondaire (41, 42, 43) et un enroulement tertiaire (31, 32, 33), dans lesquels les enroulements primaires sont reliés aux phases (PA, PB, PC) d'un système électrique triphasé et les enroulements tertiaires des transformateurs de tension sont reliés les uns aux autres par une connexion en V, dans lequel le procédé comprend :

a) la conduite d'un défaut de terre dans le système électrique triphasé en reliant à la terre une des phases (PA, PB, PC) du système électrique triphasé ;
b) la mesure d'une tension primaire à partir de la phase en défaut ;
c) la mesure de tensions secondaires à partir des enroulements secondaires (41, 42, 43) ; et
d) la détermination de valeurs d'un ou plusieurs paramètres d'impédance liés à la configuration de transformateur en utilisant la tension primaire mesurée, les tensions secondaires mesurées et une équation liant la tension primaire aux tensions secondaires et le ou les plusieurs paramètres d'impédance liés à la configuration de transformateur.

**2.** Procédé selon la revendication 1, **caractérisé en ce que**, lorsque le nombre des paramètres d'impédance dont les valeurs sont déterminées est de deux ou plus, l'étape d) comprend :

la découverte par itération de telles valeurs des deux ou plusieurs paramètres d'impédance liés à la configuration de transformateur qui minimisent une différence entre la valeur mesurée de la tension primaire et une valeur calculée de la tension primaire obtenue en utilisant l'équation, les tensions secondaires mesurées et les valeurs des deux ou plusieurs paramètres d'impédance ; et

la sélection des valeurs trouvées en tant que valeurs déterminées des deux ou plusieurs paramètres d'impédance liés à la configuration de transformateur.

3. Procédé selon la revendication 1 ou 2, **caractérisé en ce que** les étapes a) à d) sont effectuées pour toutes les trois phases (PA, PB, PC).

4. Procédé selon la revendication 1, 2 ou 3, **caractérisé en ce que** les paramètres d'impédance liés à la configuration de transformateur comprennent un ou plusieurs paramètres d'impédance des transformateurs de tension (11, 12, 13), un ou plusieurs paramètres d'impédance d'un circuit connecté aux enroulements secondaires (41, 42, 43) et/ou un ou plusieurs paramètres d'impédance d'un circuit connecté aux enroulements tertiaires (31, 32, 33).

5. Procédé selon la revendication 4, **caractérisé en ce que** les paramètres d'impédance des transformateurs de tension (11, 12, 13) comprennent une impédance de l'enroulement primaire (21, 22, 23), une impédance de l'enroulement secondaire (41, 42, 43) et/ou une impédance de l'enroulement tertiaire (31, 32, 33).

6. Procédé selon la revendication 4 ou 5, **caractérisé en ce que** les paramètres d'impédance du circuit connecté aux enroulements secondaires (41, 42, 43) comprennent une impédance de charge secondaire et/ou une impédance de câblage secondaire.

7. Procédé selon la revendication 6, **caractérisé en ce que** les paramètres d'impédance du circuit connecté aux enroulements secondaires (41, 42, 43) comprennent une impédance de conducteur neutre secondaire lorsque les impédances de charge secondaires sont reliées en étoile.

8. Procédé selon n'importe laquelle des revendications 4 à 7, **caractérisé en ce que** les paramètres d'impédance du circuit connecté aux enroulements tertiaires (31, 32, 33) comprennent une impédance de charge tertiaire et/ou une impédance de câblage tertiaire.

9. Agencement pour déterminer des valeurs de paramètres d'impédance liés à une configuration de transformateur comprenant trois transformateurs de tension monopolaires (11, 12, 13) chacun ayant au moins un enroulement primaire (21, 22, 23), un enroulement secondaire (41, 42, 43) et un enroulement tertiaire (31, 32, 33), dans lesquels les enroulements primaires sont connectés aux phases (PA, PB, PC) d'un système électrique triphasé et les enroulements tertiaires des transformateurs de tension sont reliés les uns aux autres par une connexion en V, dans lequel l'agencement comprend :

un moyen (70) pour conduire un défaut de terre dans le système électrique triphasé en reliant à la terre une des phases (PA, PB, PC) du système électrique triphasé ;
un moyen (70) pour mesurer une tension primaire à partir de la phase en défaut ;
un moyen (70) pour mesurer des tensions secondaires à partir des enroulements secondaires (41, 42, 43) ; et
un moyen (70) pour déterminer des valeurs d'un ou plusieurs paramètres d'impédance liés à la configuration de transformateur en utilisant la tension primaire mesurée, les tensions secondaires mesurées et une équation liant la tension primaire aux tensions secondaires et le ou les plusieurs paramètres d'impédance liés à la configuration de transformateur.

10. Agencement selon la revendication 9, **caractérisé en ce que**, lorsque le nombre des paramètres d'impédance dont des valeurs doivent être déterminées est de deux ou plus, le moyen de détermination (70) comprend un moyen pour la découverte par itération de telles valeurs des deux ou plusieurs paramètres d'impédance liés à la configuration de transformateur qui minimisent une différence entre la valeur mesurée de la tension primaire et une valeur calculée de la tension primaire obtenue en utilisant l'équation, les tensions secondaires mesurées et les valeurs des deux ou plusieurs paramètres d'impédance ; et
la sélection des valeurs trouvées en tant que valeurs déterminées du ou des plusieurs paramètres d'impédance liés à la configuration de transformateur.

11. Agencement selon la revendication 9 ou 10, **caractérisé en ce que** les paramètres d'impédance liés à la configuration de transformateur comprennent un ou plusieurs paramètres d'impédance des transformateurs de tension (11, 12, 13), un ou plusieurs paramètres d'impédance d'un circuit connecté aux enroulements secondaires (41, 42, 43) et/ou un ou plusieurs paramètres d'impédance d'un circuit connecté aux enroulements tertiaires (31, 32, 33).

12. Agencement selon la revendication 11, **caractérisé en ce que** les paramètres d'impédance des transformateurs de tension (11, 12, 13) comprennent une impédance de l'enroulement primaire (21, 22, 23), une impédance de l'enroulement secondaire (41, 42, 43) et/ou une impédance de l'enroulement tertiaire (31, 32, 33).

13. Agencement selon la revendication 11 ou 12, **caractérisé en ce que** les paramètres d'impédance du circuit connecté aux enroulements secondaires (41, 42, 43) comprennent une impédance de charge secondaire et/ou une impédance de câblage secondaire.

14. Agencement selon la revendication 13, **caractérisé en ce que** les paramètres d'impédance du circuit connecté aux enroulements secondaires (41, 42, 43) comprennent une impédance de conducteur neutre secondaire lorsque les impédances de charge secondaires sont reliées en étoile.

15. Agencement selon n'importe laquelle des revendications 11 à 14, **caractérisé en ce que** les paramètres d'impédance du circuit connecté aux enroulements tertiaires (31, 32, 33) comprennent une impédance de charge tertiaire et/ou une impédance de câblage tertiaire.

Fig. 1

A •—— Primary winding

N •——
⏚

Measuring winding •—— a

•—— n

Earth-fault winding •—— da

•—— dn

Fig. 2

20

30

40

50

40

30        20

60

⏚

Fig. 3

PC

PB

PA

11    12    13

21 A    22    23

N

31 da    32    33

dn

Rd

n

41    42    43

a

22

Fig. 4

Fig. 5

$$\text{Fig. 6}$$

$$\overline{U}xp\_meas$$

$$\overline{U}as$$

$$\overline{U}bs$$

$$\overline{U}cs$$

70

Parameter
values

CONT

**EP 2 378 296 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1727257 A
- EP 1324455 A
- JP 5180885 A